**Europäisches Patentamt**

**European Patent Office**

**Office européen des brevets**

(11) Numéro de publication: **0 283 374 B1**

# FASCICULE DE BREVET EUROPEEN

(45) Date de publication de fascicule du brevet: **12.08.92**

(51) Int. Cl.⁵: **C23C 14/56**, C23C 14/26

(21) Numéro de dépôt: **88400522.4**

(22) Date de dépôt: **04.03.88**

(54) **Dispositif d'évaporation sous vide d'un métal en continu.**

(30) Priorité: **06.03.87 FR 8703092**

(43) Date de publication de la demande:
**21.09.88 Bulletin 88/38**

(45) Mention de la délivrance du brevet:
**12.08.92 Bulletin 92/33**

(84) Etats contractants désignés:
**AT BE CH DE ES FR GB GR IT LI LU NL SE**

(56) Documents cités:
**DE-A- 2 030 688**
**FR-A- 1 069 111**
**FR-A- 2 456 144**
**US-A- 4 395 179**

(73) Titulaire: **CENTRE NATIONAL D'ETUDES SPA-TIALES**
**2 Place Maurice-Ouentin**
**F-75039 Paris Cedex 01(FR)**

(72) Inventeur: **Rémondière, Olivier**
**11, Avenue Emile Zola**
**F-31520 Ramonville Saint Agné(FR)**
Inventeur: **Bourquin, Patrick**
**36, rue Sainte Colombe**
**F-33000 Bordeaux(FR)**
Inventeur: **Pailler, René**
**29, Allée de la Lande**
**F-33610 Cestas(FR)**

(74) Mandataire: **Mongrédien, André et al**
**c/o BREVATOME 25, rue de Ponthieu**
**F-75008 Paris(FR)**

## Description

La présente invention se rapporte au domaine de l'évaporation sous vide de métaux et plus particulièrement au cas où l'on cherche à effectuer cette opération en continu afin de réaliser un dépôt sur un substrat continu, tel qu'un fil ou une bande. On peut ainsi réaliser des dépôts, des co-dépôts, des revêtements ou des protections par des procédés tels que la condensation ou le placage ionique.

Ces techniques servent au dépôt des métaux en phase vapeur et s'appliquent dans de nombreux domaines tels que la microélectronique, le revêtement des matières plastiques, la protection de pièces métalliques contre la corrosion ou l'élaboration de matériaux composites.

Les sources d'évaporation sont généralement statiques, c'est-à-dire que le métal présent au départ dans les sources est évaporé partiellement ou complètement durant l'opération de revêtement. Il est alors nécessaire de recharger les sources d'évaporation, ce qui implique des opérations onéreuses car il faut ouvrir l'enceinte à vide pour introduire une nouvelle quantité de métal et effectuer un nouveau pompage pour refaire le vide. On peut remédier à cet inconvénient en utilisant des sources statiques de grande capacité afin de contenir une grande quantité du métal à évaporer. Mais, dans ce cas, il est nécessaire d'avoir une grande puissance de chauffage pour évaporer cette quantité de métal et le contrôle de la régularité du taux d'évaporation en fonction du temps est délicat. Ces inconvénients sont particulièrement gênants dans le cas où la quantité de métal est très grande, et également dans le cas où la durée de fonctionnement est importante, par exemple lorsque le substrat est continu et défile devant une ou plusieurs sources d'évaporation.

On a encore utilisé des sources à fonctionnement continu. Par exemple, le metal à évaporer peut se présenter sous la forme d'un fil qui alimente au fur et à mesure de l'opération un creuset chauffé par effet Joule, par haute fréquence ou par tout autre moyen. Le fil est fondu au fur et à mesure qu'il arrive dans la phase de métal liquide contenue dans le creuset, et c'est la masse liquide qui se vaporise. Ce système est actuellement employé dans le domaine de l'aéronautique pour le dépôt d'aluminium servant à protéger les pièces contre la corrosion, ainsi que pour l'élaboration de matériaux composites, par exemple aluminium-fibres de carbone. Le brevet japonais n° 58 120 876 décrit un procédé de ce type.

Si l'utilisation d'un fil permet l'évaporation de grandes quantités de métal et un fonctionnement de longue durée sans qu'il soit nécessaire d'avoir une puissance de chauffage trop élevée, cette façon de faire présente des inconvénients lorsque le métal utilisé est du magnésium. En effet, ce métal a une température d'ébullition très basse (1107°C dans les conditions normales de température et de pression) et, dans les conditions d'évaporation sous vide habituellement utilisées dans les techniques de dépôt en phase vapeur, la phase liquide n'est pas présente entre la phase solide et la phase vapeur. Cela signifie que le fil d'alimentation ne peut pas tremper dans un bain de métal fondu, mais est immédiatement vaporisé dès qu'il arrive en contact avec le creuset ou dès que sa température est suffisamment élevée. La surface chaude à partir de laquelle se produit l'émission de vapeur est donc très réduite par rapport à celle que l'on peut obtenir à l'aide d'une masse liquide : il s'ensuit que la vitesse de dépôt est beaucoup plus faible.

Un autre élément à prendre en considération est qu'un fil de magnésium n'est pas un produit courant et il faudrait le fabriquer à la demande. Ceci entraînerait une augmentation notable du coût du produit final, ce qui est d'autant plus regrettable que le substrat (fibre étalée de carbone, de carbure de silicium ou d'alumine dans le cas de l'élaboration de matériaux composites par exemple), qui est en fait la partie essentielle du produit final, se trouverait alors moins cher que la matrice. Enfin, la faible résistance mécanique et le manque de rigidité d'un fil de magnésium compliqueraient notablement le système d'alimentation.

C'est pourquoi on a songé à alimenter les sources d'évaporation par des métaux se présentant sous forme de poudre, de granules ou de toute autre forme divisée permettant une alimentation quasi-continue. Cependant, dans le cas du magnésium, la tension de vapeur importante de ce métal dans les conditions habituelles d'évaporation des procédés de dépôt en phase vapeur, ainsi que sa faible densité (1,74), entraînent un soulèvement et des mouvements importants des grains de poudre dès que ceux-ci sont introduits dans le creuset chauffé. Ces mouvements sont vraisemblablement dus au dégagement brutal de vapeur lorsque les grains sont chauffés rapidement car leur capacité calorifique est de 0,25 cal/g.°C. Ce dégagement brutal de vapeur communique une quantité de mouvement importante aux grains de poudre, ces mouvements pouvant ensuite être entretenus par convection. Ainsi, les grains de poudre sont rapidement éjectés hors du creuset et il en résulte un mauvais rendement, le rendement étant défini comme le rapport entre la quantité de métal évaporée et la quantité de métal introduite. Ce rendement peut descendre jusqu'à des valeurs de l'ordre de 1 ou 2% seulement. D'autre part, les grains ainsi éjectés peuvent être projetés sur le système d'alimentation et boucher celui-ci à plus ou moins long terme par la coalescence des grains éjectés ainsi que par la condensation de la vapeur métallique, ce qui entraîne l'interruption de la production.

La présente invention a pour but de remédier à ces inconvénients en proposant un dispositif d'évaporation sous vide d'un matériau qui assure un rendement très élevé (voisin de 100%) tout en éliminant les risques de bouchage du système d'alimentation du creuset.

De façon plus précise, l'invention concerne un dispositif d'évaporation d'un metal, utilisable dans une enceinte à vide, comprenant, de manière connue :

- un creuset ;
- des moyens d'introduction du matériau à l'état de particules dans le creuset ; et
- des moyens pour provoquer l'évaporation du matériau lorsqu'il est dans le creuset.
  Selon l'invention :
- le creuset est fermé et comporte, dans une de ses parois, au moins un orifice d'évaporation dont les dimensions sont suffisamment faibles pour que les particules du métal présentes dans le creuset ne puissent s'échapper ;
- lesdits moyens d'introduction comprennent :
  . un orifice d'alimentation, différent de l'orifice d'évaporation, prévu dans une paroi du creuset et pouvant être obturé au moins partiellement pendant une durée déterminée ;
  . un clapet déplaçable entre une position de fermeture dans laquelle il obture l'orifice d'alimentation du creuset et une position d'ouverture ;
  . un réservoir placé à une certaine distance du creuset et ayant un orifice permettant le passage du matériau ;
  . des moyens de guidage du matériau du réservoir au creuset ;
  . un obturateur déplaçable entre une position de fermeture dans laquelle il ferme l'orifice du réservoir et une position d'ouverture ; et
  . des moyens pour commander l'ouverture et la fermeture du clapet et de l'obturateur.

Le mot "particule" est utilisé ici dans son sens le plus général et désigne les éléments solides qui constituent le matériau, ceux-ci pouvant être des grains, billes, sphères, microsphères, copeaux, etc.

Quant à l'orifice d'évaporation, ses dimensions sont telles que décrit plus haut, c'est-à-dire suffisamment faibles pour que seule la vapeur puisse s'échapper et non pas les particules. Ces dernières ont une granulométrie donnée mais, en arrivant dans le creuset, leur taille diminue car une partie du matériau s'évapore. De plus, à l'intérieur du creuset, ces particules sont animées de mouvements aléatoires. Les dimensions de l'orifice d'évaporation sont déterminées pour que la majorité des particules présentes dans le creuset ne s'échappe pas, même lorsque leurs dimensions ont été réduites par évaporation. Il est possible cependant qu'une très faible proportion des particules ait des dimensions extrêmement faibles et puisse s'échapper malgré tout. De toute façon, ceci ne se produit que pour une très faible quantité de matériau et n'a pratiquement pas d'influence sur le rendement du dispositif.

On peut prévoir, dans une paroi du creuset, une fenêtre fermée par une grille à mailles fines dont les mailles ont des dimensions telles que définies plus haut : chaque maille de la grille constitue ainsi un orifice d'évaporation.

Dans un premier mode de réalisation, les moyens de commande sont agencés de manière à réaliser l'ouverture et la fermeture simultanées du clapet et de l'obturateur. De préférence, le réservoir se trouve au-dessus du creuset afin que le matériau s'écoule par gravité du réservoir au creuset. Dans ce premier mode de réalisation, lesdits moyens de commande peuvent comprendre :

- une liaison mécanique entre l'obturateur et le bouchon ;
- un bras rigide sur lequel est monté ledit obturateur, ce bras pouvant pivoter autour d'un axe ; et
- des moyens pour faire pivoter ce bras.

De préférence, lesdits moyens de pivotement comprennent :

- au moins un électroaimant ayant un noyau mobile entre deux positions ;
- une tige rigide solidaire de ce noyau et reliée à une pièce solidaire du bras par une articulation située à une certaine distance de l'axe.

Dans un deuxième mode de réalisation, les moyens de commande sont agencés de sorte que l'ouverture et la fermeture du clapet soient indépendantes de celles de l'obturateur.

Dans ce cas, les moyens de commande comprennent :

- des moyens de rappel du clapet vers sa position d'ouverture,
- un premier électroaimant ayant un noyau mobile entre une première position et une deuxième position,
- une première liaison mécanique entre le clapet et le noyau du premier électroaimant, l'excitation de ce dernier entraînant le déplacement de son noyau et de la première liaison mécanique dans le sens qui provoque la fermeture du clapet,
- des moyens de rappel de l'obturateur vers sa position de fermeture,
- un deuxième électroaimant différent du premier, ayant un noyau mobile entre une première position et une deuxième position, et

- une deuxième liaison mécanique entre l'obturateur et le noyau du deuxième électroaimant, l'excitation de ce dernier entraînant le déplacement de son noyau et de la deuxième liaison mécanique dans le sens qui provoque l'ouverture de l'obturateur.

Enfin, selon un dernier aspect de l'invention, le dispositif comporte en outre :

- un ensemble de réflecteur placés à l'extérieur du creuset autour de l'orifice d'évaporation de manière à diriger les vapeurs émises dans une direction déterminée, et
- des moyens pour maintenir ces réflecteur à une température supérieure à la température d'évaporation du métal.

L'invention apparaîtra mieux à la lecture de la description qui va suivre, donnée à titre d'exemple purement illustratif et nullement limitatif, en référence aux dessins annexés, dans lesquels :

- la figure 1 est une vue schématique en coupe verticale d'un premier mode de réalisation du dispositif objet de l'invention, et
- la figure 2 est une vue schématique en coupe verticale d'un deuxième mode de réalisation de ce dispositif.

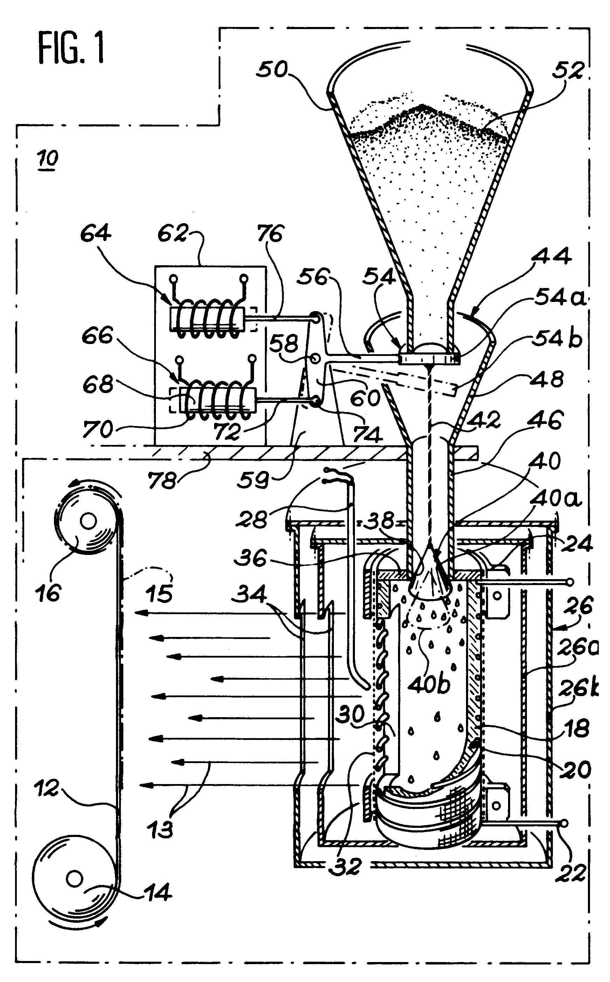

Si l'on se reporte à la figure 1, on voit une enceinte 10, représentée schématiquement en traits mixtes, à l'intérieur de laquelle on a fait le vide. Le substrat à revêtir 12 peut être, par exemple, un ruban qui défile depuis une bobine émettrice 14 jusqu'à une bobine réceptrice 16. A l'intérieur de l'enceinte 10 se trouve le dispositif d'évaporation objet de l'invention. Celui-ci comprend d'abord un creuset 18 qui peut être de forme cylindrique et disposé verticalement sur un support (non représenté), ce creuset se trouvant au même niveau que la partie du substrat 12 située entre les bobines 14 et 16. Le creuset 18 est chauffé par tout moyen connu, par exemple une résistance 20 reliée une alimentation électrique (non représentée) par des fils tels que 22. Si nécessaire, le creuset est maintenu par des colliers de serrage 24 placés à sa partie supérieure et à sa partie inférieure. Il peut être entouré par un ou plusieurs réflecteur 26 dont le rôle est de diminuer les pertes par rayonnement. Dans l'exemple décrit ici, il y a deux réflecteurs 26a et 26b se présentant chacun sous la forme d'un manchon cylindrique dont la paroi interne est réfléchissante. Ces réflecteurs sont disposés concentriquement au creuset. Un thermocouple 28, placé dans l'espace compris entre le réflecteur interne 26a et le creuset, et disposé de telle sorte que son extrémité soit en contact avec celui-ci, permet de connaître la température de ce creuset. De préférence, les réflecteurs 26 sont fermés à leurs extrémités supérieure et inférieure afin de limiter les pertes thermiques.

On voit encore sur la figure 1 que la paroi du creuset est percée d'une fenêtre 30 fermée par une grille à mailles fines 32, la disposition étant telle que cette grille fait face au substrat à revêtir 12. Le rôle de cette grille est de permettre le passage de la vapeur de métal tout en empêchant le passage des grains métalliques solides comme on le verra plus loin lorsqu'on décrira le fonctionnement de l'appareil. Pour cela, les mailles de la grille 32 ont des dimensions inférieures à celles des plus petits grains présents dans le creuset. Les réflecteurs 26 comportent eux aussi des fenêtres 34 en face de la grille 32 afin de permettre le passage de la vapeur du métal.

Le creuset 18 est fermé à sa partie supérieure par une paroi 36 percée en son centre d'une ouverture circulaire 38. Cette dernière peut être obturée par un bouchon ou clapet 40 déplaçable entre une position de fermeture 40a et une position d'ouverture 40b. Ce bouchon est manoeuvré à l'aide d'un câble 42, dont le fonctionnement sera décrit ci-dessous. Le bouchon 40 se présente sous la forme d'un cône et il se trouve à l'intérieur du creuset. Le diamètre de l'ouverture 38 est inférieur au diamètre du cône constituant le bouchon. Ainsi, lorsque ce dernier est remonté depuis l'intérieur du creuset par l'intermédiaire du câble 42, il arrive un moment où le bouchon est bloqué contre l'ouverture 38, fermant ainsi le creuset.

Au-dessus de cette ouverture et à l'extérieur du creuset se trouve un premier entonnoir 44 composé d'une partie cylindrique 46 surmontée d'une partie évasée 48. La partie inférieure de la partie cylindrique ou goulotte 46 est fixée de manière étanche à la paroi supérieure 36 du creuset autour de l'ouverture 38. Dans l'exemple décrit ici, la partie inférieure de la goulotte 46 se trouve exactement au niveau de l'ouverture 38, mais on ne sortirait pas du cadre de l'invention si la goulotte 46 pénétrait plus ou moins à l'intérieur du creuset : le bouchon 40 serait alors placé de manière à obturer l'extrémité de cette goulotte. De toute façon, il faudrait fermer l'orifice 38 de manière étanche afin d'empêcher le passage de la vapeur ou des grains de métal à cet endroit. Le câble 42 est placé pratiquement suivant l'axe de l'entonnoir 44. Un second entonnoir 50 contenant le métal en poudre 52 est placé au-dessus du premier entonnoir 44. Ce deuxième entonnoir 50 est maintenu l'intérieur de l'enceinte 10 par un moyen de fixation approprié qui, pour la clarté du dessin, n'a pas été représenté. L'entonnoir 50 est fermé à sa partie inférieure par une plaque 54 montée à une extrémité d'un bras rigide 56 pouvant pivoter autour d'un axe 58 horizontal. Ce dernier est monté sur un support 59 fixe par rapport à l'enceinte 10. A l'extrémité du bras 56 opposée à la plaque 54 est fixé un autre bras 60 perpendiculaire au bras 56 de sorte que c'est l'ensemble des deux bras 56 et 60 qui peut pivoter autour de l'axe 58. Eventuellement, les deux bras 56 et 60 peuvent constituer une seule pièce en forme de T. Ainsi, la plaque 54 est mobile entre une position de fermeture 54a, représentée en traits pleins sur le dessin, et une position d'ouverture 54b représentée schématiquement en traits mixtes. Cette position d'ouverture est obtenue après un pivotement de l'ensemble 54, 56, 60 d'un certain angle autour de l'axe 58, dans le sens des aiguilles d'une montre en regardant le dessin.

Le câble 42 a une première extrémité fixée à la partie supérieure du bouchon 40 et son autre extrémité fixée à la face inférieure de la plaque 54. Sa longueur est telle que, lorsque la plaque 54 est en position de fermeture 54a, le bouchon 40 est en position de fermeture 40a et, lorsque la plaque 54 est en position d'ouverture 54b, le bouchon 40 est en position d'ouverture 40b.

Les bras 56 et 60, et donc la plaque 54, sont manoeuvrés au moyen d'un dispositif de commande 62 qui comprend deux électroaimants superposés, à savoir un électroaimant supérieur 64 et un électroaimant inférieur 66. Chacun de ces électroaimants, par exemple l'électroaimant inférieur 66, se compose essentiellement d'un noyau 68 cylindrique entouré d'une bobine 70. Le noyau 68 est mobile longitudinalement et il est relié au bras 60 par une tige rigide 72. De préférence, cette dernière est placée suivant l'axe du noyau 68. La liaison entre la tige 72 et le bras 60 est une articulation 74. De même, le noyau de l'électroaimant 64 est relié par une tige 76 au bras 60 en un point situé au-dessus de l'axe 58. Le dispositif de commande 62, ainsi que le support 59 de l'axe 58, repose sur un support 78 prévu à l'intérieur de l'enceinte 10. Celui-ci peut être muni d'une ouverture permettant le passage de la partie inférieure 46 de l'entonnoir 44, ce qui permet de maintenir ce dernier. Cependant, on ne sortirait pas du cadre de l'invention en utilisant d'autres moyens pour maintenir l'entonnoir 44. Mais de toute façon, il est préférable que la liaison entre celui-ci et la paroi supérieure du creuset soit étanche afin que les grains de métal solide contenus dans le creuset ne s'échappent pas à travers l'ouverture 38.

On va maintenant décrire le fonctionnement du dispositif illustré à la figure 1.

Au départ, on fait le vide dans l'enceinte 10 et on alimente la résistance chauffante 20 afin que le creuset atteigne une température permettant l'évaporation du métal à déposer sur le substrat. Au départ, le clapet 40 et la plaque 54 sont en position de fermeture 40a, 54a. Dans cette position, les articulations des tiges 72 et 76 sur le bras 60 se trouvent sur la même ligne verticale et, dans l'exemple décrit ici, elles sont à égale distance de l'axe 58. Il s'ensuit que, dans cette position, le bras 56 est horizontal et le bras 60 vertical. Dans cette position également, les bobines alimentant les électroaimants 64 et 66 sont excitées de sorte que le noyau de l'électroaimant supérieur soit poussé vers la gauche en regardant le dessin et que le noyau 68 de l'électroaimant 66 soit poussé vers la droite en regardant le dessin. Lorsqu'on veut introduire dans le creuset une certaine quantité de métal, on excite les bobines des électroaimants de sorte que le noyau de l'électroaimant 64 soit poussé vers la droite et que le noyau de l'électroaimant 66 soit poussé vers la gauche. Ainsi, les tiges 76 et 72 se déplacent horizontalement vers la droite et vers la gauche, respectivement. Il s'ensuit un pivotement de la plaque 54 et des bras 56 et 60 autour de l'axe 58, ce qui amène la plaque 54 en position d'ouverture 54b. Ceci a également pour effet que le bouchon 40 est amené en position d'ouverture 40b. Ainsi, une certaine quantité de poudre métallique 52 sort de l'entonnoir 50 à la partie inférieure de celui-ci et tombe à l'intérieur de l'entonnoir 44. Comme l'ouverture 38 est au moins partiellement dégagée, la poudre tombe à l'intérieur du creuset où elle est chauffée rapidement jusqu'à sa température d'ébullition. Au bout d'un certain temps, déterminé en fonction de la quantité de poudre qu'on veut introduire dans le creuset à chaque cycle, les bobines des électroaimants sont alimentées en sens inverse, de sorte que le noyau de l'électroaimant 64 est à nouveau poussé vers la gauche et que le noyau de l'électroaimant 66 est nouveau poussé vers la droite. Ceci a pour effet de faire pivoter la plaque 54 et les bras 56 et 60 autour de l'axe 58 dans le sens inverse des aiguilles d'une montre en regardant le dessin; la plaque 54 est donc ramenée à sa position de fermeture 54a, et le bouchon 40 à sa position de fermeture 40a.

La masse de poudre métallique ainsi introduite à l'intérieur du creuset est portée assez rapidement à une température suffisante pour que le métal se vaporise. La vapeur ainsi produite s'échappe du creuset par la grille 32 sous l'effet de la différence de pression entre le creuset et l'enceinte. Cette différence de pression provient de la formation de vapeur à l'intérieur du creuset alors que l'enceinte est vide. Le creuset, ainsi que les réflecteurs 26, sont orientés de telle sorte que la vapeur se dirige vers le substrat 12, comme cela est symbolisé par les flèches 13, et se dépose sur le substrat en formant une couche 15 représentée schématiquement en traits mixtes sur la figure 1. Bien entendu, le défilement du substrat 12 a été commandé avant la première introduction de poudre dans le creuset.

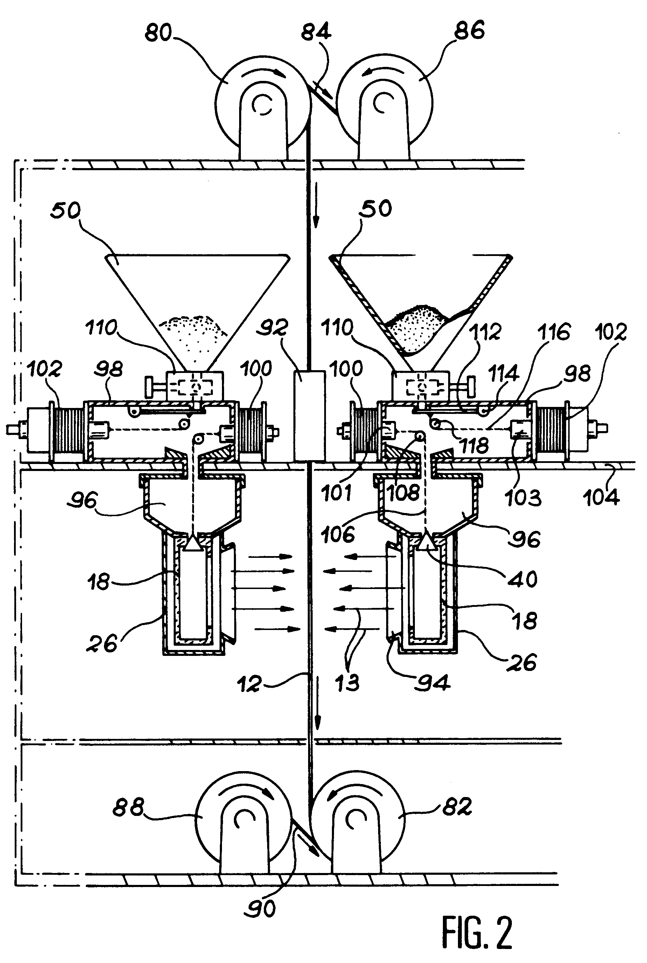

La figure 2 illustre un autre mode de réalisation du dispositif objet de l'invention. Pour plus de clarté, les éléments identiques à ceux de la figure 1 portent les mêmes numéros de référence. On retrouve le substrat 12 (par exemple une fibre de carbone) qui est émis par une bobine émettrice 80 et s'enroule sur une bobine réceptrice 82. Le papier d'aluminium 84 qui protège la fibre vierge est enroulé sur une bobine 86 tandis qu'une bobine 88 émet le papier d'aluminium servant à protéger la fibre imprégnée. Le substrat 12 passe dans un four de dégazage 92 avant d'arriver au niveau du creuset.

Dans l'exemple décrit ici, il y a deux dispositifs selon l'invention, placés de part et d'autre du substrat, afin de réaliser un dépôt uniforme. Bien entendu, on ne sortirait pas du cadre de l'invention en utilisant un nombre quelconque de tels dispositifs, leur répartition étant déterminée en fonction de la qualité du revêtement qu'on veut obtenir. Comme les deux dispositifs sont identiques, un seul sera décrit.

On retrouve le creuset 18 entouré d'un ou plusieurs réflecteurs 26 pour la protection thermique. Le creuset 18 et les réflecteurs 26 présentent des fenêtres permettant le passage de la vapeur (flèches 13). Avantageusement, on peut prévoir un ensemble de réflecteurs 94 disposés à l'extérieur du creuset et placés de manière à diriger la vapeur vers le substrat. Un dispositif de chauffage (non représenté) permet de maintenir les réflecteurs 94 à une température supérieure à la température d'évaporation du matériau. Ainsi, les vapeurs émises sont bien dirigées vers le substrat, ce qui améliore le rendement du dépôt. Bien entendu, des réflecteurs tels que 94 peuvent aussi être utilisés avec le mode de réalisation de la figure 1.

Le creuset 18 comporte une ouverture dans sa partie supérieure qui le met en communication avec une chambre 96. Celle-ci communique, à sa partie supérieure, avec l'intérieur d'un boîtier 98. Deux électroaimants 100 et 102 dont le rôle sera décrit plus loin, sont fixés sur des parois du boîtier 98. Ce dernier ainsi que les deux électroaimants sont placés sur un support 104 prévu à l'intérieur de l'enceinte à vide. La chambre 96 et le creuset 18 se trouvent sous le support 104.

L'ouverture prévue à la partie supérieure du creuset 18 peut être obturée par un bouchon conique 40. Celui-ci est relié, par un câble 106 passant sur une poulie ou un renvoi d'angle 108, au noyau 101 de l'électroaimant 100.

Le réservoir de poudre en forme d'entonnoir 50 est placé à l'extérieur du boîtier 98 et au-dessus de ce dernier. Il est équipé à sa partie inférieure d'un système d'arrêt de l'alimentation en magnésium 110 et communique avec l'intérieur du boîtier 98 par un orifice qui peut être obturé par un clapet 112. Ce clapet peut pivoter autour d'un axe 114 et il est relié par un câble 116 passant sur une poulie 118 au noyau 103 de l'électroaimant 102. Un ressort de rappel (non représenté) ramène le clapet 112 en position de fermeture. De préférence, les orifices faisant communiquer le réservoir 50 avec le boîtier 98, le boîtier 98 avec la chambre 96 et celle-ci avec le creuset 18 se trouvent sur la même ligne verticale.

Le fonctionnement du dispositif illustré à la figure 2 est le suivant :

Au départ, le bouchon 40 et le clapet 112 sont en position de fermeture, c'est-à-dire que les noyaux 101 et 103 des électroaimants 100 et 102 sont déplacés vers la gauche en regardant la figure 2. Dans cette situation, l'électroaimant 100 est excité et l'électroaimant 102 ne l'est pas. Le bouchon 40 peut être sollicité en position d'ouverture par un ressort de rappel (non représenté). Lorsqu'on désire introduire une certaine quantité de poudre dans le creuset, on active l'électroaimant 102 : le noyau 103 se déplace vers la droite en regardant la figure et le câble 116 fait pivoter le clapet 112 à l'encontre de la force exercée par son ressort de rappel.

On désexcite ensuite l'électroaimant 100 pour que le noyau 101 se déplace vers la droite en regardant la figure, entraînant l'ouverture du bouchon 40 sous l'effet de son ressort de rappel. Lorsque la quantité voulue de poudre a été introduite dans le creuset, on désexcite l'électroaimant 102 et le ressort de rappel du clapet 112 le ramène en position de fermeture. Lorsque les dernières particules sont tombées dans le creuset, on excite l'électroaimant 100 pour que le noyau 101 soit déplacé vers la gauche en regardant le dessin, ce qui a pour effet de ramener le bouchon 40 en position de fermeture. Au bout d'un temps déterminé, on recommence le cycle.

Cette façon de faire, et notamment le fait que la fermeture du bouchon 40 ait lieu après celle du clapet 112, permet à la totalité du matériau extrait du réservoir 50 d'être introduite dans le creuset et on évite que des particules ne restent dans les éléments intermédiaires.

On va maintenant décrire quelques exemples de revêtements qui ont été effectués à l'aide d'un dispositif conforme l'invention et à l'aide de dispositifs selon l'art antérieur.

EXEMPLE 1

Un dispositif comme celui qui est illustré sur la figure 1 a été utilisé comme source d'évaporation de magnésium dans un appareillage permettant d'élaborer un "préimprégné", c'est-à-dire un semi-produit fibreux constitué, dans cet exemple, de fibres de carbone étalées puis enrobées de magnésium par PVD (déposition en phase vapeur). Les grains de poudre de magnésium utilisés avaient une forme pratiquement sphérique et un diamètre moyen de 0,5 mm.

On a réalisé d'autres essais en faisant varier les conditions expérimentales. C'est ainsi qu'on a utilisé différentes poudres dont le diamètre moyen était compris entre 0,3 et 2,5 mm, la morphologie des grains étant aléatoire. On a utilisé des cadences d'alimentation différentes allant jusqu'à 5 grammes par minute, la température du creuset étant comprise entre 500 et 700°C et la pression à l'intérieur de l'enceinte étant comprise entre 1,35 et $1,35.10^{-4}$ Pa ($10^{-2}$ à $10^{-6}$ torr).

Dans tous les cas, on a constaté un rendement entre la quantité de métal évaporée et la quantité introduite dans le creuset proche de 100%. Aucune perte de poudre n'a été constatée, ce qui permet de penser que toute la poudre a été transformée en vapeur.

Un tel dispositif peut fonctionner aussi longtemps qu'on le désire, l'arrêt n'intervenant que lorsque la totalité du substrat 12 a défilé devant le creuset 18 ou lorsque la réserve de poudre de l'entonnoir 50 est épuisée. Après démontage, on n'a constaté aucun dépôt de métal ou début de bouchage au niveau du clapet d'alimentation 40, ni au niveau de la goulote 46. On a ainsi pu réaliser plusieurs centaines de mètres de pré-imprégnés en fibres de carbone revêtues de magnésium sans opération de maintenance sur les systèmes d'évaporation et avec une cadence de production élevée.

EXEMPLE 2

Dans cet exemple, on a essayé de revêtir des fibres de carbone avec du magnésium dans les mêmes conditions que dans l'exemple 1, mais en utilisant un creuset ouvert, c'est-à-dire en supprimant le grillage 32. On a constaté qu'à chaque arrivée de poudre dans le creuset, celle-ci ressortait immédiatement par l'orifice 30 en n'ayant produit que très peu de vapeur. Le rendement entre la quantité de métal évaporée et la quantité introduite dans le creuset est tellement faible qu'il n'a pu être pratiquement mesuré.

EXEMPLE 3

Dans cet exemple, on a essayé de refaire les mêmes essais qu'à l'exemple 1 en conservant la grille 32, mais en supprimant le clapet d'alimentation 40. On a pu constater que, dans ces conditions, la poudre versée dans le creuset est immédiatement renvoyée vers l'orifice d'alimentation 38 : une partie s'agglutine vers l'entrée du creuset ou au niveau de la goulotte 46 suivant la température tandis que l'autre partie, redescendant dans le creuset, est immédiatement renvoyée par l'émission d'un nouveau flux de vapeur. Au bout d'une durée variable en fonction de la cadence d'alimentation, de la température et de la géométrie du dispositif (cette durée variant de quelques minutes à plusieurs heures), la goulotte d'alimentation 46 est bouchée. Une opération de démontage et de nettoyage est alors nécessaire pour reprendre la production. Pendant la période de fonctionnement, le rendement entre la quantité de métal évaporée et la quantité introduite dans le creuset est de l'ordre de 10 à 50%.

On voit donc que le dispositif objet de l'invention présente des avantages particulièrement intéressants vis-à-vis des dispositifs de l'art antérieur dont le principal est d'avoir un rendement très élevé, généralement proche de 100%, et en tout cas supérieur à 50%. Ceci vient d'une part du fait que le creuset est fermé par le clapet d'alimentation 40 une fois que la quantité désirée de poudre est introduite et, d'autre part, du fait que la grille 32 présente des orifices de très faible diamètre permettant le passage de la vapeur et interdisant le passage des grains. Ainsi, tout le métal contenu à l'intérieur du creuset est évaporé et s'échappe à travers la grille 32 et, même s'il y a des mouvements à l'intérieur du creuset dus à la création de vapeur, les grains ne remontent pas à travers l'ouverture 38, ni le long de la goulotte 36. Comme les grains sont maintenus à l'intérieur du creuset, où la température est réglée à une valeur permettant l'évaporation du métal, il ne peut pas y avoir de condensation sur les parois du creuset et tout risque de bouchage est éliminé. De plus, comme l'alimentation du creuset est intermittente, on peut régler à volonté la quantité de métal introduite à chaque ouverture.

D'autre part, comme le creuset est fermé, les parties du dispositif en contact avec la poudre métallique, c'est-à-dire essentiellement les entonnoirs 44 et 50 et la plaque 54, sont à une température inférieure à celle du creuset, et donc à une température inférieure à celle pouvant provoquer une évaporation du métal. Cette condition est nécessaire car, si elle n'était pas remplie, il y aurait une agglomération de particules préjudiciable à leur transfert vers le creuset.

Enfin, il est bien entendu que l'invention ne se limite pas aux seuls modes de réalisation qui viennent d'être décrits ici, mais qu'on peut imaginer des variantes sans sortir pour autant du cadre de l'invention. C'est ainsi que l'homme du métier pourra faire varier la forme et les dimensions du creuset, ainsi que les moyens de chauffage de celui-ci, et/ou faire varier le nombre de réflecteurs en fonction des conditions d'utilisation. Quant aux moyens d'alimentation du creuset en poudre métallique, si on a décrit deux modes de réalisation qui sont simples et pratiques, on ne sortirait pas non plus du cadre de l'invention en utilisant un autre système d'alimentation, pourvu qu'il permette une alimentation intermittente du creuset. On peut aussi utiliser tout moyen approprié pour fixer ou maintenir les différents éléments du dispositif à l'intérieur de l'enceinte notamment le creuset, les réflecteurs, les entonnoirs et le système de commande de la plaque 54.

Enfin, ce dispositif est utilisable quelle que soit la forme sous laquelle se présente le métal, poudre, granules, billes ou copeaux. Il peut être utilisé quel que soit le métal à déposer et quel que soit le substrat, par exemple un pré-imprégné fibreux constitué de fibres multibrins de carbone ou de carbure de silicium préalablement étalées, puis métallisées sous vide.

## Revendications

1. Dispositif d'évaporation d'un métal, utilisable dans une enceinte à vide, comprenant :
   - un creuset (18),
   - des moyens d'introduction du métal (52) à l'état de particules dans le creuset (18) ; et
   - des moyens (20) pour provoquer l'évaporation du métal (52) lorsqu'il est dans le creuset (18),
   caractérisé en ce que :
   - le creuset (18) est fermé et comporte, dans une de ses parois, au moins un orifice d'évaporation dont les dimensions sont suffisamment faibles pour que les particules du métal présentes dans le creuset ne puissent s'échapper ;
   - lesdits moyens d'introduction comprennent :
     . un orifice d'alimentation, différent de l'orifice d'évaporation, prévu dans une paroi du creuset (18) et pouvant être obturé au moins partiellement pendant une durée déterminée ;
     . un clapet (40) déplaçable entre une position de fermeture dans laquelle il obture l'orifice d'alimentation du creuset (18) et une position d'ouverture ;
     . un réservoir (50) placé à une certaine distance du creuset et ayant un orifice permettant le passage du métal (52) ;
     . des moyens de guidage (44) du métal (52) du réservoir (50) au creuset (18) ;
     . un obturateur (54) déplaçable entre une position de fermeture dans laquelle il ferme l'orifice du réservoir (50) et une position d'ouverture ; et
     . des moyens pour commander l'ouverture et la fermeture du clapet (40) et de l'obturateur (54).

2. Dispositif selon la revendication 1, caractérisé en ce que le creuset (18) comporte, dans une de ses parois, une fenêtre fermée par une grille (32) dont les mailles ont des dimensions suffisamment faibles pour que les particules du métal présentes dans le creuset ne puissent s'échapper, les mailles de la grille constituant un ensemble d'orifices d'évaporation.

3. Dispositif selon la revendication 1, caractérisé en ce que lesdits moyens de commande sont agencés de manière à réaliser l'ouverture et la fermeture simultanées du clapet (40) et de l'obturateur (54).

4. Dispositif selon la revendication 3, caractérisé en ce que, l'obturateur (54) se trouvant au-dessus du clapet (40), lesdits moyens de commande comprennent :
   - une liaison mécanique (42) entre l'obturateur (54) et le bouchon (40);
   - un bras rigide (56) sur lequel est monté ledit obturateur (54), ce bras pouvant pivoter autour d'un axe (58) ; et
   - des moyens (62) pour faire pivoter ce bras (56).

5. Dispositif selon la revendication 4, caractérisé en ce que lesdits moyens de pivotement comprennent :
   - au moins un électroaimant (66) ayant un noyau (68) mobile entre deux positions ; et
   - une tige rigide (72) solidaire de ce noyau (68) et reliée à une pièce (60) solidaire du bras (56) par une articulation (74) située à une certaine distance de l'axe (58).

6. Dispositif selon la revendication 1, caractérisé en ce que lesdits moyens de commande sont agencés de sorte que l'ouverture et la fermeture du clapet (40) soient indépendantes de celles de l'obturateur.

7. Dispositif selon la revendication 6, caractérisé en ce que lesdits moyens de commande comprennent :
   - des moyens de rappel du clapet (40) vers sa position d'ouverture ;
   - un premier électroaimant (100) ayant un noyau (101) mobile entre une première position et une deuxième position ;
   - une première liaison mécanique (106) entre le clapet (40) et le noyau (101) du premier électroaimant (100), l'excitation de ce dernier entraînant le déplacement de son noyau et de la première liaison mécanique dans le sens qui provoque la fermeture du clapet (40) ;
   - des moyens de rappel de l'obturateur (112) vers sa position de fermeture ;
- un deuxième électroaimant (102), différent du premier, ayant un noyau (103) mobile entre une première position et une deuxième position ; et
- une deuxième liaison mécanique (116) entre l'obturateur (112) et le noyau (103) du deuxième électroaimant (102), l'excitation de ce dernier entraînant le déplacement de son noyau et de la deuxième liaison mécanique dans le sens qui provoque l'ouverture de l'obturateur (112).

8. Dispositif selon la revendication 1, caractérisé en ce qu'il comporte en outre :
- un ensemble de réflecteurs (94) placés à l'extérieur du creuset autour de l'orifice d'évaporation (18) de manière à diriger les vapeurs émises dans une direction déterminée ; et
- des moyens pour maintenir ces réflecteurs (94) à une température supérieure à la température d'évaporation du métal.

## Claims

1. Apparatus for the evaporation of a metal usable in a vacuum chamber, comprising:
a crucible (18),
means for introducing the metal (52) in the particle state into the crucible (18), and
means (20) for bringing about the evaporation of the metal (52) when it is in the crucible (18), characterized in that:
the crucible (18) is sealed and has in one of its walls at least one evaporation opening, whose dimensions are sufficiently small to ensure that the particles of the metal present in the crucible cannot escape; said introduction means comprising:
a supply opening, different from the evaporation opening, provided in one wall of the crucible (18) and which can at least partly be sealed for a predetermined time;
a valve (40) displaceable between a closed position in which it seals the supply opening of the crucible (18) and an open position;
a reservoir (50) placed at a certain distance from the crucible and having an opening permitting the passage of the metal (52);
means (44) for guiding the metal (52) from the reservoir (50) to the crucible (18);
a closure (54) displaceable between a closed position in which it closes the opening of the reservoir (50) and an open position; and means for controlling the opening and closing of the valve (50) and the closure (54).

2. Apparatus according to claim 1, characterized in that the crucible (18) has, in one of its walls, a window closed by a screen (32), whose meshes have sufficiently small dimensions to ensure that the metal particles present in the crucible cannot escape, the meshes of the screen constituting a plurality of evaporation openings.

3. Apparatus according to claim 1, characterized in that the control means are arranged in such a way as to bring about the simultaneous opening and closing of the valve (40) and the closure (54).

4. Apparatus according to claim 3, characterized in that the closure (54) is located above the valve (40), so that the control means comprise a mechanical link (42) between the closure (54) and the valve (40), a rigid arm (56) on which is mounted said closure (54), said arm being able to pivot about an axis (58) and means (62) for pivoting said arm (56),

5. Apparatus according to claim 4, characterized in that said pivoting means comprise at least one electromagnet (66) having a core (68) moving between two positions and a rigid rod (72) integral with said core (68) and connected to a part (60) integral with the arm (56) by an articulation (74) located at a certain distance from the axis (58).

6. Apparatus according to claim 1, characterized in that said control means are arranged in such a way that the opening and closing of the valve (40) are independent of those of the closure.

7. Apparatus according to claim 6, characterized in that said control means comprise:
means for returning the valve (40) to its open position;
a first electromagnet (100) having a core (101) moving between a first position and a second position;
a first mechanical link (106) between the valve (40) and the core (101) of the first electromagnet (100), the excitation of the latter leading to the displacement of its core and the first mechanical link in the direction causing the closure of the valve (40);
means for returning the closure (112) to its closed position;
a second electromagnet (102), different from the first, having a core (103) moving between a first position and a second position; and
a second mechanical link (116) between the closure (112) and the core (103) of the second electromagnet (102), the excitation of the latter bringing about the displacement of its core and the second mechanical link in the direction bringing about the opening of the closure (112).

8. Apparatus according to claim 1, characterized in that it also comprises a plurality of reflectors (94) located outside the crucible around the evaporation opening (18) such a way as to direct the vapours discharged in a given direction and means for maintaining these reflectors (94) at a temperature above the evaporation temperature of the metal.

## Patentansprüche

1. Anlage zum Verdampfen eines Metalls, die in einer Vakuumhülle verwendbar ist, mit:
   - einem Tiegel (18),
   - Vorrichtungen zum Einführen des Metalls (52) in Zustand von Teilchen in den Tiegel (18); und
   - Vorrichtungen (20) zum Bewirken der Verdampfung des Metalls (52), sobald es sich in dem Tiegel (18) befindet, dadurch gekennzeichnet, daß:
   - der Tiegel (18) geschlossen ist und in einer seiner Wände wenigstens eine Verdampfungsöffnung umfaßt, deren Ausmaße hinreichend klein sind, damit die in dem Tiegel vorhandenen Metallteilchen nicht entweichen können;
   - die Einführungsvorrichtungen umfassen:
     . eine Versorgungsöffnung, die von der Verdampfungsöffnung verschieden ist und die in einer Wand des Tiegels (18) vorgesehen ist und wenigstens teilweise während einer vorgegebenen Zeitdauer verschlossen werden kann;
     . ein zwischen einer Verschlußposition, in der es die Versorgungsöffnung des Tiegels (18) verschließt, und einer Öffnungsposition verschiebbares Ventil (40);
     . einen Behälter (50), der in einem bestimmten Abstand von dem Tiegel angeordnet ist und eine den Durchgang des Metalls (52) ermöglichende Öffnung besitzt;
     . Führungsvorrichtungen (44) für das Metall (52) von dem Behälter (50) zum Tiegel (18);
     . einen zwischen einer Verschlußposition, in der er die Öffnung des Behälters (50) verschließt, und einer Öffnungsposition verschiebbaren Verschluß (54); und

. Vorrichtungen zum Steuern des Öffnens und Schließens des Ventils (40) und des Verschlusses (54).

2. Anlage nach Anspruch 1, dadurch gekennzeichnet, daß der Tiegel (18) in einer seiner Wände ein von einem Gitter (32) geschlossenes Fenster besitzt, dessen Maschen hinreichend kleine Ausmaße besitzen, damit die in dem Tiegel vorhandenen Metallteilchen nicht entweichen können, wobei die Maschen des Gitters eine Anordnung von Verdampfungsöffnungen bilden.

3. Anlage nach Anspruch 1, dadurch gekennzeichnet, daß die Steuerungsvorrichtungen so betätigt werden, daß sie das gleichzeitige Öffnen und Verschließen des Ventils (40) und des Verschlusses (54) bewirken.

4. Anlage nach Anspruch 3, dadurch gekennzeichnet, daß, während sich der Verschluß (54) über dem Ventil (40) befindet, die Steuerungsvorrichtungen umfassen:
   - eine mechanische Verbindung (42) zwischen dem Vorschluß (42) und dem Stopfen (40);
   - einen starren Arm (56), an dem der Verschluß (54) montiert ist, wobei dieser Arm um eine Achse (58) schwenken kann; und
   - Vorrichtungen (62) zum Schwenken dieses Arms (56).

5. Anlage nach Anspruch 4, dadurch gekennzeichnet, daß die Schwenkvorrichtungen umfassen:
   - wenigstens einen Elektromagneten (66) mit einem zwischen zwei Positionen beweglichen Kern (68); und
   - einem starren, mit diesem Kern (68) verbundenen Schaft (72), der auch mit einem mit dem Arm (56) verbunden Teil (60) über eine gelenkige Verbindung (74) verbunden ist, die sich in einem bestimmten Abstand von der Achse (58) befindet.

6. Anlage nach Anspruch 1, dadurch gekennzeichnet, daß die Steuerungsvorrichtungen so betätigt werden, daß das Öffnen und Schließen des Ventils (40) von dem des Verschlusses unabhängig sind.

7. Anlage nach Anspruch 6, dadurch gekennzeichnet, daß die Steuerungsvorrichtungen umfassen:
   - Vorrichtungen zum Rückführen des Ventils (40) in seine Öffnungsposition;
- einen ersten Elektromagneten (100) mit einem zwischen einer ersten und einer zweiten Position beweglichen Kern (101);
- eine erste mechanische Verbindung (106) zwischen dem Ventil und dem Kern (101) des ersten Elektromagneten (100), wobei die Erregung des letzteren die Bewegung seines Kerns und der ersten mechanischen Verbindung in der Richtung, die den Verschluß des Ventils (40) bewirkt, nach sich zieht;
- Vorrichtungen zum Rückführen des Verschlusses (112) in seine Verschlußposition;
- einen zweiten, von dem ersten verschiedenen Elektromagneten (102) mit einem zwischen einer ersten und einer zweiten Position beweglichen Kern (103); und
- eine zweite mechanische Verbindung (116) zwischen dem Verschluß und dem Kern (103) des zweiten Elektromagneten (102), wobei die Erregung des letzteren die Bewegung seines Kerns und der zweiten mechanischen Verbindung in der Richtung, die die Öffnung des Verschlusses (112) bewirkt, nach sich zieht.

8. Anlage nach Anspruch 1, dadurch gekennzeichnet, daß sie außerdem umfaßt:
- eine Anordnung von Reflektoren (94), die derart außerhalb des Tiegels um die Verdampfungsöffnung (18) angeordnet sind, daß sie die ausgesandten Dämpfe in eine bestimmte Richtung richten; und
- Vorrichtungen, um diese Reflektoren (94) auf einer Temperatur oberhalb der Verdampfungstemperatur des Metalls zu halten.

FIG. 1

FIG. 2